# EUROPÄISCHE PATENTSCHRIFT

(11) **EP 0 525 313 B1**
(45) Veröffentlichungstag und Bekanntmachung des Hinweises auf die Patenterteilung: **28.02.1996**
(21) Anmeldenummer: 92108116.2
(22) Anmeldetag: 14.05.1992
(51) Int. Cl.: H01L 39/20, H02H 9/02, H01L 39/24

(54) **Resistiver Strombegrenzer und Verfahren zu seiner Herstellung**
Resistive current limiter and method of making it
Limiteur de courant résistif et méthode pour sa fabrication

(30) Priorität: 18.06.1991 DE 4119983
(43) Veröffentlichungstag der Anmeldung: 03.02.1993
(73) Patentinhaber: HOECHST AKTIENGESELLSCHAFT, D-65926 Frankfurt am Main (DE)
(72) Erfinder: Preisler, Eberhard Dr., W-5042 Erfstadt (DE); Bock, Joachim Dr., W-5042 Erfstadt (DE)

(56) Entgegenhaltungen:
- EP-A- 0 315 976
- EP-A- 0 345 767
- PATENT ABSTRACTS OF JAPAN vol. 13, no. 483 (E-839) 2. November 1989 & JP-A-11 90 217

## Beschreibung

Die vorliegende Erfindung betrifft einen resistiven Strombegrenzer sowie ein Verfahren zu seiner Herstellung.

Es ist bekannt, zum Schutz von großen Gleichrichteranlagen und anderen elektrotechnischen Geräten vor evtl. auftretenden Kurzschlußströmen resistive Strombegrenzer zu verwenden, die den Strom in weniger als 1 ms ausschalten. Ein solcher Strombegrenzer besteht aus einem druckfesten Isoliergehäuse, in dem sich ein Stromleiter befindet, welcher eine Sprengkapsel enthält, die durch einen Zündimpuls zur Explosion gebracht wird. Durch die Explosion der Sprengkapsel reißt der Stromleiter an einer vorbereiteten schwachen Stelle auf. Die plötzliche Stromunterbrechung läßt eine hohe Spannung entstehen, durch die der Strom auf eine aus einer Schmelzsicherung bestehenden Parallelschaltstrecke geleitet wird (vergl. "Lexikon der Energietechnik und Kraftmaschinen", Band 6, 1965, Seite 570).

Weiterhin ist bekannt, daß bei Hochtemperatur-Supraleitern für jede Temperatur unterhalb ihrer kritischen Temperatur T_{c} eine kritische Stromdichte j_{c} existiert, bei deren Überschreitung die Supraleitung zusammenbricht und der Leiter nur noch metallische Leitfähigkeit aufweist (vergl. W. BUCKEL: "Supraleitung", 3. Auflage, 1984, Seiten 172 und 173).

Nachteilig ist bei dem bekannten Strombegrenzer, daß er durch den auftretenden Kurzschlußstrom zerstört wird und deshalb anschließend ausgewechselt werden muß.

Die EP-A-0 315 976 beschreibt eine Anordnung in Form eines Hohlzylinders, welcher als Strombegrenzer fungiert und aus Hochtemperatur-Supraleiter-Material besteht und der durch das Wikkeln von Drähten auf einen isolierenden Zylinder erhalten wurde. Über die Effizienz des Strombegrenzers und seine eventuelle Wiederverwendbarkeit liegen keine Angaben vor.

Es ist daher Aufgabe der vorliegenden Erfindung, einen resistiven Strombegrenzer sowie ein Verfahren zu seiner Herstellung anzugeben, wobei der resistive Strombegrenzer für mehrfaches Auftreten von Kurzschlußströmen geeignet ist. Das wird erfindungsgemäß dadurch erreicht, daß der resistive Strombegrenzer aus Hochtemperatur-Supraleiter-Material besteht und in Form eines Hohlyzylinders vorliegt, welcher dadurch gekennzeichnet ist, daß der Hohlzylinder einen parallel zu seiner Achse verlaufenden Spalt mit einer Vielzahl von parallel zu diesem Spalt verlaufenden Schlitzen aufweist.

Der resistive Strombegrenzer gemäß der Erfindung kann auch noch dadurch weitergebildet sein, daß
a) die Schlitze in den Hohlzylinder abwechselnd von seiner Oberseite und von seiner Unterseite her eingeschnitten sind;
b) die Breite des Spaltes mindestens 0,5 mm beträgt;
c) das Hochtemperatur-Surpaleiter-Material ein polynäres Oxid ist;
d) das polynäre Oxid Bismut, Calcium, Strontium und Kupfer enthält;
e) das polynäre Oxid zusätzlich Blei enthält;
f) der Hohlzylinder in seinem Bereich zwischen dem Spalt und dem ersten Schlitz jeweils mit einer Stromzuführungsleitung bzw. Stromabführungsleitung elektrisch leitend verbunden ist;
g) der Abstand der Schlitze voneinander so gewählt ist, daß beim Überschreiten der kritischen Stromdichte der sich im Hochtemperatur-Supraleiter-Material unterhalb seiner Sprungtemperatur einstellende Widerstand eine eine Minderung des kritischen Stromes bewirkende Größe aufweist.

Ein erfindungsgemäßer resistiver Strombegrenzer kann dadurch hergestellt werden, daß man eine homogene Schmelze aus einem zur Bildung von Hochtemperatur-Supraleitern geeigneten Oxidgemisch in vorgegebener Stöchiometrie herstellt, daß man die Schmelze mit Temperaturen oberhalb von 900 °C in eine um ihre waagerechte Achse rotierende Gießzone einlaufen läßt, daß man das als Hohlzylinder erstarrte Formteil aus der Gießzone entnimmt, daß man den Hohlzylinder unter Ausbildung eines parallel zu seiner Achse verlaufenden Spaltes aufsägt, daß man in dem Hohlzylinder parallel zu dem Spalt eine Vielzahl von Schlitzen einsägt und daß man schließlich den Hohlzylinder bis zu 150 Stunden bei 700 bis 900 °C in sauerstoffenthaltender Atmosphäre tempert.

Die Herstellung des resisitiven Strombegrenzers kann weiterhin auch noch dadurch ausgestaltet sein, daß
h) das Oxidgemisch Bismut, Calcium, Strontium und Kupfer enthält;
i) das Oxidgemisch zusätzlich Blei enthält;
j) die Stöchiometrie gemäß der Formel Bi₂Sr₂CaCu₂Oₓ, wobei x für Werte zwischen 8 und 8,5 steht, vorgegeben ist;
k) die Stöchiometrie gemäß der Formel (Bi,Pb)₂Sr₂Ca₂Cu₃Oₓ, wobei x für Werte zwischen 10 und 13 steht, vorgegeben ist.

Der erfindungsgemäße resistive Strombegrenzer, welcher beim Überschreiten einer kritischen Stromstärke seine supraleitenden Eigenschaften verliert und zu einem Ohm'schen Widerstand wird, kehrt aber sofort in den supraleitenden Zustand zurück, sobald durch ihn kein überkritischer Strom mehr fließt.

Die Schlitze im resistiven Strombegrenzer gemäß der Erfindung bewirken eine Verlängerung des Leiterweges durch das Hochtemperatur-Supraleiter-Material.

Beim erfindungsgemäßen resistiven Strombegrenzer hängt die maximale Stromstärke, welche den Strombegrenzer noch passieren kann, von der kritischen Stromdichte des Hochtemperatur-Supraleiter-Materials unterhalb seiner Sprungtemperatur und vom Leiterquerschnitt ab.

Beim resistiven Strombegrenzer gemäß der Erfindung müssen die Länge und der Querschnitt des Hochtemperatur-Supraleiter-Materials durch den Abstand der Schlitze voneinander und damit durch ihre Anzahl so gestaltet sein, daß beim Überschreiten der kritischen Stromdichte im HochtemperaturSupraleiter-Material der sich unterhalb seiner Sprungtemperatur einstellende Widerstand so groß ist, daß eine Minderung des kritischen Stromes eintritt, d.h. die Bedingung I_{Ohm} < I_{krit.} erfüllt ist.

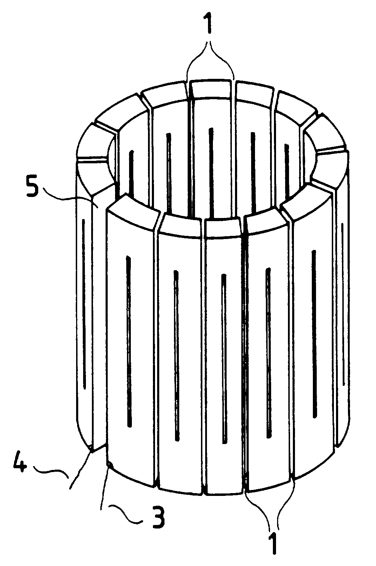

In der beigefügten Zeichnung ist ein Ausführungsbeispiel des Gegenstandes der Erfindung schematisch dargestellt.

Der aus Hochtemperatur-Supraleiter-Material bestehende Hohlzylinder weist einen parallel zu seiner Achse verlaufenden Spalt 5 von 5 mm Breite auf. Parallel zu diesem Spalt 5 ist der Hohlzylinder mit 27 Schlitzen 1 versehen, welche abwechselnd vom oberen und vom unteren Ende des Hohlzylinders her eingeschnitten sind. Im Bereich zwischen dem Spalt 5 und dem ersten rechts befindlichen Schlitz 1 ist der Hohlzylinder mit einer Stromzuführungsleitung 3 und im Bereich zwischen dem Spalt 5 und dem ersten links befindlichen Schlitz 1 mit einer Stromabführungsleitung 4 elektrisch leitend verbunden.

### Beispiel

In einem Aluminiumoxidtiegel wurden 800 g der sog. Zweischichtverbindung Bi₂Sr₂CaCu₂Oₓ (mit x = 8,2) aufgeschmolzen und 20 Minuten bei einer Temperatur von 1030°C gehalten. Dann wurde die Schmelze über eine Gießrinne in einen waagerecht angeordneten und mit 500 Upm rotierenden Topf mit einem Durchmesser von 10 cm und 11 cm Höhe eingebracht. Nach Abkühlen wurde aus dem Topf ein Hohlzylinder mit 10 cm Durchmesser, 11 cm Höhe und 4 mm Wandstärke entnommen. Der Hohlzylinder wurde in Luft 24 Stunden auf 750°C und 120 Stunden auf 850°C erhitzt, wodurch er zu einem Supraleiter mit einer kritischen Temperatur von 91 K und einer kritischen Stromdichte von 230 A cm⁻ wurde.

In den Hohlzylinder wurden abwechselnd von seinem oberen und seinem unteren Rand her 10 cm lange Schlitze in Abständen von 3,5 mm eingeschnitten, so daß die Breite der dadurch ausgebildeten Lamellen 3 mm betrug. Schließlich wurde ein Schlitz von 5 mm Breite völlig durchgezogen, so daß der Hohlzylinder an einer Stelle parallel zu seiner Achse durchgetrennt war. An den beiden Seiten der Trennstelle wurde der Hohlzylinder mit je einer Stromzuführungsleitung bzw. Stromabführungsleitung elektrisch leitend verbunden (vergl. die Figur).

Bei 77 K konnte durch den so hergerichteten Hohlzylinder ein Wechselstrom von 27 A verlustlos transportiert werden, wobei durch eine Erhöhung der Spannung keine höhere Stromstärke erreicht wurde.

## Patentansprüche (Patentansprüche für folgende(n) Vertragsstaat(en): AT, BE, CH, DE, FR, GB, GR, IT, LI, LU, NL, SE)

1. Aus Hochtemperatur-Supraleiter-Material bestehender und in Form eines Hohlzylinders vorliegender resistiver Strombegrenzer, dadurch gekennzeichnet, daß der Hohlzylinder einen parallel zu seiner Achse verlaufenden Spalt (5) mit einer Vielzahl von parallel zu diesem Spalt (5) verlaufenden Schlitzen (1) aufweist.

2. Resistiver Strombegrenzer nach Anspruch 1, dadurch gekennzeichnet, daß die Schlitze (1) in den Hohlzylinder abwechselnd von seiner Oberseite und von seiner Unterseite her eingeschnitten sind.

3. Resistiver Strombegrenzer nach Anspruch 1 oder 2, dadurch gekennzeichnet, daß die Breite des Spaltes (5) mindestens 0,5 mm beträgt.

4. Resistiver Strombegrenzer nach mindestens einem der Ansprüche 1 bis 3, dadurch gekennzeichnet, daß das Hochtemperatur-Supraleiter-Material ein polynäres Oxid ist.

5. Resistiver Strombegrenzer nach Anspruch 4, dadurch gekennzeichnet, daß das polynäre Oxid Bismut, Calcium, Strontium und Kupfer enthält.

6. Resistiver Strombegrenzer nach Anspruch 5, dadurch gekennzeichnet, daß das polynäre Oxid zusätzlich Blei enthält.

7. Resistiver Strombegrenzer nach mindestens einem der Ansprüche 1 bis 6, dadurch gekennzeichnet, daß der Hohlzylinder in seinem Bereich zwischen dem Spalt (5) und dem ersten Schlitz (1) jeweils mit einer Stromzuführungsleitung (3) bzw. Stromabführungsleitung (4) elektrisch leitend verbunden ist.

8. Resistiver Strombegrenzer nach mindestens einem der Ansprüche 1 bis 7, dadurch gekennzeichnet, daß der Abstand der Schlitze (1) voneinander so gewählt ist, daß bei Überschreiten der kritischen Stromdichte der sich im Hochtemperatur-Supraleiter-Material unterhalb seiner Sprungtemperatur einstellende Widerstand eine eine Minderung des kritischen Stromes bewirkende Größe aufweist.

9. Verfahren zur Herstellung eines resisitiven Strombegrenzers nach mindestens einem der Ansprüche 1 bis 8, dadurch gekennzeichnet, daß man eine homogene Schmelze aus einem zur Bildung von Hochtemperatur-Supraleitern geeigneten Oxidgemisch in vorgegebener Stöchiometrie herstellt, daß man die Schmelze mit Temperaturen oberhalb von 900 °C in eine um ihre waagerechte Achse rotierende Gießzone einlaufen läßt, daß man das als Zylinder erstarrte Formteil aus der Gießzone entnimmt, daß man den Zylinder unter Ausbildung eines parallel zu seiner Achse verlaufenden Spaltes aufsägt, daß man in dem Zylinder parallel zu dem Spalt eine Vielzahl von Schlitzen einsägt und daß man schließlich den Zylinder bis zu 150 Stunden bei 700 bis 900 °C in sauerstoffenthaltender Atmosphäre tempert.

10. Verfahren nach Anspruch 9, dadurch gekennzeichnet, daß das Oxidgemisch Bismut, Calcium, Strontium und Kupfer enthält.

11. Verfahren nach Anspruch 10, dadurch gekennzeichnet, daß das Oxidgemisch zusätzlich Blei enthält.

12. Verfahren nach Anspruch 9, dadurch gekennzeichnet, daß die Stöchiometrie gemäß der Formel (Bi,Pb)₂Sr₂CaCu₂Oₓ, wobei x für Werte zwischen 8 und 8,5 steht, vorgegeben ist.

13. Verfahren nach Anspruch 11, dadurch gekennzeichnet, daß die Stöchiometrie gemäß der Formel (Bi,Pb)₂Sr₂Ca₂Cu₃Oₓ, wobei x für Werte zwischen 10 und 13 steht, vorgegeben ist.

## Patentansprüche (Patentansprüche für folgende(n) Vertragsstaat(en): ES)

1. Verfahren zur Herstellung eines resistiven Strombegrenzers, dadurch gekennzeichnet, daß man eine homogene Schmelze aus einem zur Bildung von Hochtemperatur-Supraleitern geeigneten Oxidgemisch in vorgegebener Stöchiometrie herstellt, daß man die Schmelze mit Temperaturen oberhalb von 900°C in eine um ihre waagerechte Achse rotierende Gießzone einlaufen läßt, daß man das als Hohlzylinder erstarrte Formteil aus der Gießzone entnimmt, daß man den Hohlzylinder unter Ausbildung eines parallel zu seiner Achse verlaufenden Spaltes aufsägt, daß man in den Hohlzylinder parallel zu dem Spalt eine Vielzahl von Schlitzen einschneidet und daß man schließlich den Hohlzylinder bis zu 150 Stunden bei 700 bis 900°C in sauerstoffenthaltender Atmosphäre tempert.

2. Verfahren nach Anspruch 1, dadurch gekennzeichnet, daß das Oxidgemisch Bismut, Calcium, Strontium und Kupfer enthält.

3. Verfahren nach Anspruch 2, dadurch gekennzeichnet, daß das Oxidgemisch zusätzlich Blei enthält.

4. Verfahren nach Anspruch 1, dadurch gekennzeichnet, daß die Stöchiometrie gemäß der Formel Bi₂Sr₂CaCu₂Oₓ, wobei x für Werte zwischen 8 und 8,5 steht, vorgegeben ist.

5. Verfahren nach Anspruch 1, dadurch gekennzeichnet, daß die Stöchiometrie gemäß der Formel (Bi,Pb)₂Sr₂Ca₂Cu₃Oₓ, wobei x für Werte zwischen 10 und 13 steht, vorgegeben ist.

6. Verfahren nach mindestens einem der Ansprüche 1 bis 5, dadurch gekennzeichnet, daß der Spalt eine Breite von 0,5 bis 5 mm aufweist.

7. Verfahren nach mindestens einem der Ansprüche 1 bis 6, dadurch gekennzeichnet, daß die Schlitze in den Hohlzylinder abwechselnd von seiner Oberseite und von seiner Unterseite her eingeschnitten sind.

8. Verfahren nach mindestens einem der Ansprüche 1 bis 7, dadurch gekennzeichnet, daß der Hohlzylinder in seinem Bereich zwischen dem Spalt und dem ersten Schlitz jeweils mit einer Stromzuführungsleitung bzw. Stromabführungsleitung elektrisch leitend verbunden ist.

9. Verfahren nach mindestens einem der Ansprüche 1 bis 8, dadurch gekennzeichnet, daß der Abstand der Schlitze voneinander so gewählt ist, daß bei Überschreiten der kritischen Stromdichte der sich im Hochtemperatur-Supraleiter-Material unterhalb seiner Sprungtemperatur einstellende Widerstand eine eine Minderung des kritischen Stromes bewirkende Größe aufweist.

## Claims (Claims for the following Contracting State(s): AT, BE, CH, DE, FR, GB, GR, IT, LI, LU, NL, SE)

1. A resistive current limiter which is composed of high-temperature superconducting material and is in the form of a hollow cylinder wherein the hollow cylinder has a gap (5) extending parallel to its axis with a multiplicity of slits (1) extending parallel to this gap (5).

2. The resistive current limiter as claimed in claim 1, wherein the slits (1) in the hollow cylinder are incised alternately from its upper side and from its lower side.

3. The resistive current limiter as claimed in claim 1 or 2, wherein the width of the gap (5) is not less than 0.5 mm.

4. The resistive current limiter as claimed in at least one of claims 1 to 3, wherein the high-temperature superconducting material is a polynary oxide.

5. The resistive current limiter as claimed in claim 4, wherein the polynary oxide contains bismuth, calcium, strontium and copper.

6. The resistive current limiter as claimed in claim 5, wherein the polynary oxide additionally contains lead.

7. The resistive current limiter as claimed in at least one of claims 1 to 6, wherein the hollow cylinder is connected in an electrically conducting manner to a current supply lead (3) or current drain lead (4) in each case in its region between the gap (5) and the first slit (1).

8. The resistive current limiter as claimed in at least one of claims 1 to 7, wherein the spacing of the slits (1) from one another is so chosen that, if the critical current density is exceeded, the resistance established in the high-temperature superconducting material below its critical temperature has a magnitude which effects a reduction in the critical current.

9. A process for producing a resistive current limiter as claimed in at least one of claims 1 to 8, which comprises producing a homogeneous melt from an oxide mixture, suitable for forming high-temperature superconductors, in a specified stoichiometry, allowing the melt to run, at temperatures above 900°C, into a casting zone rotating about its horizontal axis, removing the molding, solidified as a cylinder, from the casting zone, sawing the cylinder so as to form a gap extending parallel to its axis, sawing a multiplicity of slits into the cylinder parallel to the gap and, finally, heat-treating the hollow cylinder for up to 150 hours at 700 to 900°C in an oxygen-containing atmosphere.

10. The process as claimed in claim 9, wherein the oxide mixture contains bismuth, calcium, strontium and copper.

11. The process as claimed in claim 10, wherein the oxide mixture additionally contains lead.

12. The process as claimed in claim 9 wherein the stoichiometry is specified in accordance with the formula (Bi,Pb)₂Sr₂CaCu₂Oₓ, where x stands for values between 8 and 8.5.

13. The process as claimed in claim 11, wherein the stoichiometry is specified in accordance with the formula (Bi,Pb)₂Sr₂Ca₂Cu₃Oₓ, where x stands for values between 10 and 13.

## Claims (Claims for the following Contracting State(s): ES)

1. A process for producing a resistive current limiter, which comprises producing a homogeneous melt from an oxide mixture, suitable for forming high-temperature superconductors, in a specified stoichiometry, allowing the melt to run, at temperatures above 900°C, into a casting zone rotating about its horizontal axis, removing the molding, solidified as a hollow cylinder, from the casting zone, sawing the hollow cylinder so as to form a gap extending parallel to its axis, incising a multiplicity of slits into the hollow cylinder parallel to the gap and, finally, heat-treating the hollow cylinder for up to 150 hours at 700 to 900°C in an oxygen-containing atmosphere.

2. The process as claimed in claim 1, wherein the oxide mixture contains bismuth, calcium, strontium and copper.

3. The process as claimed in claim 2, wherein the oxide mixture additionally contains lead.

4. The process as claimed in claim 1, wherein the stoichiometry is specified in accordance with the formula Bi₂Sr₂CaCu₂Oₓ, where x stands for values between 8 and 8.5.

5. The process as claimed in claim 1, wherein the stoichiometry is specified in accordance with the formula (Bi,Pb)₂Sr₂Ca₂Cu₃Oₓ, where x stands for values between 10 and 13.

6. The process as claimed in at least one of claims 1 to 5, wherein the gap has a width of from 0.5 to 5mm.

7. The process as claimed in at least one of claims 1 to 6, wherein the slits in the hollow cylinder are incised alternately from its upper side and from its lower side.

8. The process as claimed in at least one of claims 1 to 7, wherein the hollow cylinder is connected in an electrically conducting manner to a current supply lead or current drain lead in each case in its region between the gap and the first slit.

9. The process as claimed in at least one of claims 1 to 8, wherein the spacing of the slits from one another is so chosen that, if the critical current density is exceeded, the resistance established in the high-temperature superconducting material below its critical temperature has a magnitude which effects a reduction in the critical current.

## Revendications (Revendications pour l'(les) Etat(s) contractant(s) suivant(s): AT, BE, CH, DE, FR, GB, GR, IT, LI, LU, NL, SE.)

1. Limiteur de courant résistif constitué d'un matériau supraconducteur à haute température et présent dans la forme d'un cylindre creux, caractérisé en ce que le cylindre creux présente une fente (5) parallèle à son axe avec de nombreuses rainures (1) parallèles à cette fente (5).

2. Limiteur de courant résistif selon la revendication 1, caractérisé en ce que les rainures (1) sont alternativement taillées dans le cylindre creux à partir de son côté supérieur et de son côté inférieur.

3. Limiteur de courant résistif selon la revendication 1 ou 2, caractérisé en ce que la largeur de la fente (5) est d'au moins 0,5 mm.

4. Limiteur de courant résistif selon l'une quelconque des revendications 1 à 3, caractérisé en ce que le matériau supraconducteur à haute température est un oxyde polynaire.

5. Limiteur de courant résistif selon la revendication 4, caractérisé en ce que l'oxyde polynaire contient du bismuth, du calcium, du strontium et du cuivre.

6. Limiteur de courant résistif selon la revendication 5, caractérisé en ce que l'oxyde polynaire contient en outre du plomb.

7. Limiteur de courant résistif selon l'une quelconque des revendications 1 à 6, caractérisé en ce que le cylindre creux est électroconductivement raccordé dans son domaine entre la fente (5) et la première rainure (1) respectivement à une ligne d'alimentation de courant (3) et à une ligne de sortie de courant (4).

8. Limiteur de courant résistif selon l'une quelconque des revendications 1 à 7, caractérisé en ce qu'on choisit l'écartement des rainures (1) les unes des autres de sorte que lors d'un dépassement de la densité de courant critique, la résistance s'ajustant dans le matériau supraconducteur à haute température en dessous de son point de changement brusque de la conductivité présente une grandeur provoquant une diminution du courant critique.

9. Procédé pour la préparation d'un limiteur de courant résistif selon l'une quelconque des revendications 1 à 8, caractérisé en ce qu'on prépare dans une stoechiométrie prédéterminée une masse en fusion homogène constituée d'un mélange d'oxydes approprié pour la formation de supraconducteurs à hautes températures, en ce qu'on introduit la masse en fusion présentant des températures supérieures à 900°C dans une zone de coulée en rotation autour de son axe horizontal, en ce qu'on prélève de la zone de coulée l'ébauche solidifiée comme un cylindre, en ce qu'on scie le cylindre en formant une fente parallèle à son axe, en ce qu'on taille à la scie dans le cylindre de nombreuses rainures parallèles à la fente et en ce qu'on durcit finalement par trempe le cylindre sur une durée allant jusqu'à 150h à une température de 700 à 900°C dans une atmosphère contenant de l'oxygène.

10. Procédé selon la revendication 9, caractérisé en ce que le mélange d'oxydes contient du bismuth, du calcium, du strontium et du cuivre.

11. Procédé selon la revendication 10, caractérisé en ce que le mélange d'oxydes contient en outre du plomb.

12. Procédé selon la revendication 9, caractérisé en ce que la stoechiométrie est prédéterminée selon la formule (Bi,Pb)₂Sr₂CaCu₂Oₓ, x représentant des valeurs comprises entre 8 et 8,5.

13. Procédé selon la revendication 11, caractérisé en ce que la stoechiométrie est prédéterminée selon la formule (Bi,Pb)₂Sr₂Ca₂Cu₃Oₓ, x représentant des valeurs comprises entre 10 et 13.

## Revendications (Revendications pour l'(les) Etat(s) contractant(s) suivant(s): ES)

1. Procédé pour la préparation d'un limiteur de courant résistif, caractérisé en ce qu'on prépare dans une stoechiométrie prédéterminée une masse en fusion homogène constituée d'un mélange d'oxydes approprié pour la formation de supraconducteurs à hautes températures, en ce qu'on introduit la masse en fusion présentant des températures supérieures à 900°C dans une zone de coulée en rotation autour de son axe horizontal, en ce qu'on prélève de la zone de coulée l'ébauche solidifiée comme un cylindre creux, en ce qu'on scie le cylindre creux en formant une fente parallèle à son axe, en ce qu'on taille dans le cylindre creux de nombreuses rainures parallèles à la fente et en ce qu'on durcit finalement par trempe le cylindre creux sur une durée allant jusqu'à 150 h à une température de 700 à 900°C dans une atmosphère contenant de l'oxygène.

2. Procédé selon la revendication 1, caractérisé en ce que le mélange d'oxydes contient du bismuth, du calcium, du strontium et du cuivre.

3. Procédé selon la revendication 2, caractérisé en ce que le mélange d'oxydes contient en outre du plomb.

4. Procédé selon la revendication 1, caractérisé en ce que la stoechiométrie est prédéterminée selon la formule Bi₂Sr₂CaCu₂Oₓ, x représentant des valeurs comprises entre 8 et 8,5.

5. Procédé selon la revendication 1, caractérisé en ce que la stoechiométrie est prédéterminée selon la formule (Bi,Pb)₂Sr₂Ca₂Cu₃Oₓ, x représentant des valeurs comprises entre 10 et 13.

6. Procédé selon l'une quelconque des revendications 1 à 5, caractérisé en ce que la fente présente une largeur de 0,5 à 5 mm.

7. Procédé selon l'une quelconque des revendications 1 à 6, caractérisé en ce qu'on taille les rainures dans le cylindre creux alternativement à partir de son côté supérieur et de son côté inférieur.

8. Procédé selon l'une quelconque des revendications 1 à 7, caractérisé en ce que le cylindre creux est électroconductivement raccordé dans son domaine entre la fente et la première rainure respectivement à une ligne d'alimentation de courant et à une ligne de sortie de courant.

9. Procédé selon l'une quelconque des revendications 1 à 8, caractérisé en ce qu'on choisit l'écartement des rainures les unes des autres de sorte que lors d'un dépassement de la densité de courant critique la résistance s'ajustant dans le matériau supraconducteur à haute température en dessous de son point de changement brusque de la conductivité présente une grandeur provoquant une diminution du courant critique.
